Europäisches Patentamt

European Patent Office

Office européen des brevets

(11) Veröffentlichungsnummer: **0 345 701**
**A2**

(12) **EUROPÄISCHE PATENTANMELDUNG**

(21) Anmeldenummer: **89110150.3**

(22) Anmeldetag: **05.06.89**

(51) Int. Cl.⁴: **G01R 31/28**

(30) Priorität: **08.06.88 DE 3819488**

(43) Veröffentlichungstag der Anmeldung:
**13.12.89 Patentblatt 89/50**

(84) Benannte Vertragsstaaten:
**DE FR GB NL**

(71) Anmelder: **Siemens Aktiengesellschaft**
**Wittelsbacherplatz 2**
**D-8000 München 2(DE)**

(72) Erfinder: **Quincke, Jörg, Dipl.-Ing.**
**Passauerstrasse 6**
**D-8000 München 70(DE)**
Erfinder: **Plies, Erich, Dr.rer.nat.**
**Diesenhofener Strasse 79 c**
**D-8000 München 90(DE)**

(54) Verfahren zur Untersuchung der Latch-Up-Ausbreitung in CMOS-Schaltungen.

(57) Für den Entwickler mikroelektronischer Bauelemente ist die Kenntnis der Latch-Up-Ausbreitung in
integrierten CMOS-Schaltungen von entscheidender
Bedeutung, um deren Latch-Up-Empfindlichkeit
durch Änderungen des Designs oder technologische
Maßnahmen verringern zu können. Da die bekannten
Verfahren zur Untersuchung der Latch-Up-Ausbreitung nur eine vergleichsweise geringe zeitliche Auflösung besitzen, wird vorgeschlagen, den Latch-Up
periodisch auszulösen, die Intensität der von der
Schaltung ausgehenden Infrarotstrahlung an mehreren die Schaltung rasterförmig überdeckten Meßstellen abzutasten, an den Meßstellen jeweils festzustellen, innerhalb welcher Zeitspanne $\tau$ die Intensität der
Infrarotstrahlung einen Schwellenwert erreicht und
jeweils einen die Zeitspanne $\tau$ repräsentierenden
Meßwert ortsabhängig aufzuzeichnen.

FIG 2

## Verfahren zur Untersuchung der Latch-Up-Ausbreitung in CMOS-Schaltungen.

Die Erfindung bezieht sich auf ein Verfahren zur Untersuchung der Latch-Up-Ausbreitung in CMOS-Schaltungen nach dem Oberbegriff des Patentanspruchs 1 sowie auf eine Anordnung zur Durchführung des Verfahrens.

In integrierten CMOS-Schaltungen existieren immer parasitäre Thyristorstrukturen, deren Zündung infolge der damit einhergehenden Aufheizung der Strompfade zu einer Zerstörung des Bauelementes führen kann. Prinzipiell läßt sich der als Latch-Up bezeichnete Effekt am sprunghaften Anstieg und der Selbsthaltung des Versorgungsstroms erkennen, ohne allerdings die betroffenen Schaltungsteile identifizieren und durch eine Änderung des Designs oder technologische Maßnahmen (höhere Wannen- und Substratdotierungen, Verwendung einer niederohmigen Epitaxieschicht usw.) verbessern zu können. Es wurden deshalb eine Reihe von Verfahren zur Lokalisierung Latch-Up-empfindlicher Bereiche in integrierten CMOS-Schaltungen entwickelt (siehe beispielsweise VDI-Berichte Nr. 659 (1987), Seite 381 bis 393, Siemens Forschungs- und Entwicklungsberichte Band 13 (1984) Nr. 1, Seite 9 bis 14 und IEEE IRPS = International Reliability Physics Symposium 1984, Seite 122 bis 127). Hierbei bietet das aus IEEE IRPS bekannte Verfahren insbesondere den Vorteil, daß auch die mit konventionellen Flüssigkristalltechniken nicht lokalisierbaren primären Latch-Up-Zentren identifiziert werden können.

Der Erfindung liegt die Aufgabe zugrunde, ein Verfahren der eingangs genannten Art anzugeben, mit dem die Latch-Up-Ausbreitung in CMOS-Schaltungen mit hoher örtlicher und zeitlicher Auflösung untersucht werden kann. Weiterhin soll eine Anordnung zur Durchführung des Verfahrens angegeben werden.

Diese Aufgaben werden erfindungsgemäß durch ein Verfahren nach Patentanspruch 1 sowie durch eine Anordnung nach Patentanspruch 6 gelöst.

Der mit der Erfindung erzielbare Vorteil besteht insbesondere darin, daß die Latch-Up-Ausbreitung in CMOS-Schaltungen mit hoher zeitlicher und örtlicher Auflösung untersucht werden kann.

Während die Ansprüche 2 bis 5 bevorzugte Ausgestaltungen des Verfahrens nach Anspruch 1 betreffen, sind die Ansprüche 7 bis 9 auf Weiterbildungen der Anordnung zur Durchführung des Verfahrens gerichtet.

Die Erfindung wird im folgenden anhand der Zeichnungen näher erläutert. Hierbei zeigt

Figur 1 den schematischen Aufbau eines Raster-Laser-Mikroskops

Figur 2 ein Ausführungsbeispiel einer Anordnung zur Durchführung des erfindungsgemäßen Verfahrens

Figur 3 die Zeitabhängigkeit einiger innerhalb der erfindungsgemäßen Anordnung auftretenden Signale.

Bei dem aus IEEE/IRPS bekannten Verfahren wird die Latch-Up-Ausbreitung in CMOS-Bausteinen durch Nachweis der von der Schaltung emittierten Infrarotstrahlung untersucht. Von besonderer Bedeutung ist hierbei die infolge der elektrischen Aufheizung der Thyristorstrukturen entstehende Wärmestrahlung mit einem Intensitätsmaximum bei $\lambda$ = 8 bis 10 $\mu$m und die durch Rekombination überschüssiger Elektronen-Loch-Paare erzeugte Infrarotstrahlung mit einem Intensitätsmaximum bei $\lambda$ = 1,1 $\mu$m, die vorzugsweise im Bereich der in Durchlaßrichtung gepolten p-n-Übergänge auftritt. Um die Latch-Up-Ausbreitung in CMOS-Schaltungen mit hoher örtlicher und zeitlicher Auflösung in einem modifizierten Raster-Laser-Mikroskop untersuchen zu können wird vorgeschlagen:

- eine parasitäre Thyristorstruktur der Schaltung gesteuert durch ein Triggersignal periodisch zu zünden,

- die Intensität der Rekombinations- und/oder Wärmestrahlung (im folgenden kurz als Infrarotstrahlung bezeichnet) nacheinander an mehreren die Schaltung vorzugsweise rasterförmig überdeckenden Meßstellen zu registrieren,

- an den Meßstellen jeweils festzustellen, innerhalb welcher Zeitspanne $\tau$ nach dem Zünden des Latch-Up die Intensität I(t) der Infrarotstrahlung einen vorgegebenen Schwellenwert $I_0$ erreicht,
- jeweils einen die Zeitspanne $\tau = t_s - t_0$ repräsentierenden Meßwert aufzuzeichnen, wobei $t_0$ den Zeitpunkt des Auftretens des den Latch-Up auslösenden Triggersignals und $t_s$ den Zeitpunkt des Erreichens des Schwellenwertes $I_0$ bezeichnet
- und gegebenenfalls ein Bild der Schaltung zu erzeugen, wobei die Zeitspanne $\tau$ die Helligkeit der den Meßstellen jeweils zugeordneten Bildpunkte bestimmt.

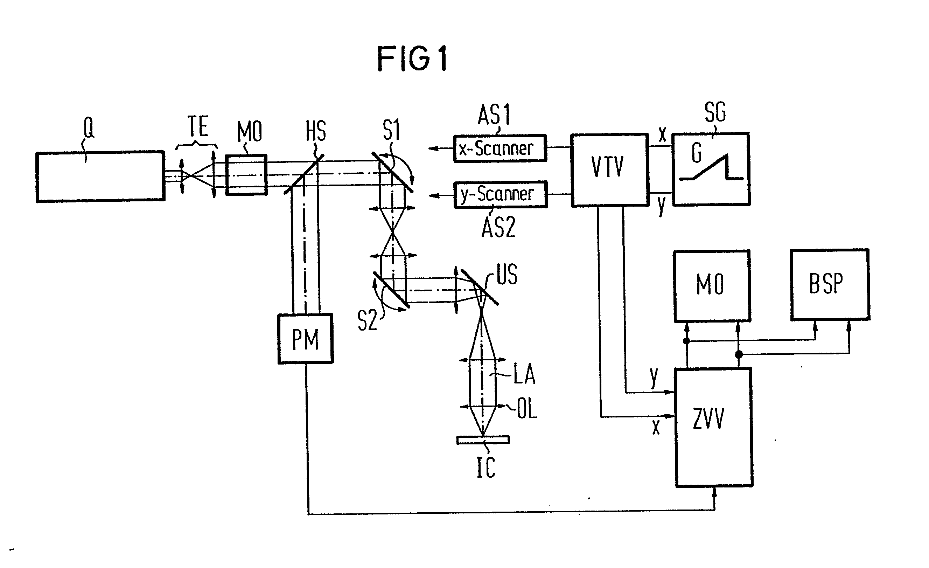

Zur Durchführung des erfindungsgemäßen Verfahrens kann man beispielsweise das aus Scanning Vol. 7 (1985), Seiten 88 bis 96, bekannte Raster-Laser-Mikroskop verwenden, dessen schematischer Aufbau in Figur 1 dargestellt ist. Es umfaßt eine Laserquelle Q (Helium-Neon-Laser), ein Teleskop TE zur Aufweitung des Laserstrahls LA, einen akustooptischen Modulator MO, einen halbdurchlässigen Spiegel HS, eine aus zwei hochgenauen Galvanometerspiegeln S1 und S2 bestehende Ablenkeinheit, einen Umlenkspiegel US und eine Objektivlinse OL zur Fokussierung des Laserstrahls LA auf die Probe IC, vorzugsweise eine integrierte CMOS-Schaltung. Außerdem ist das Raster-Laser-Mikroskop noch mit einer in Figur 1 nicht näher bezeichneten telezentrischen Optik ausgestattet, die sicherstellt, daß der Laserstrahl LA in der Objektivpupille örtlich ruht und somit nur eine Winkelbewegung mit der Pupille als Drehpunkt ausführt. Unabhängig von der Stellung der um orthogonale Achsen drehbaren Galvanometerspiegel S1 und S2 wird so mit immer die volle Öffnung der Objektivlinse OL ausgenutzt, wo bei die Strahlfleckgröße auf der Probe IC unabhängig ist vom Ort des Fokus in der Ebene der Probenoberfläche.

Die die Position des Laserstrahls LA auf der Probe IC definierenden Ablenkspannungen werden in einem hochgenauen Rastergenerator SG erzeugt und in einem Tandemverstärker VTV verstärkt, dessen Ausgangssignale an den Eingängen der den Spiegeln S1 und S2 zugeordneten Ansteuereinheiten AS1 und AS2 anliegen. Zur Erzeugung eines Auflichtbildes der Probe IC wird die in die Objektivlinse OL rückgestreute und mit Hilfe des halbdurchlässigen Spiegels HS ausgekoppelte Strahlung mit einem Photomultiplier PM nachgewiesen, dessen verstärktes Ausgangssignal die Intensität des Schreibstrahls eines Monitors MO steigert. Dem Monitor MO ist vorzugsweise ein Videoverstärker ZVV vorgeschaltet, an dessen Eingängen sowohl das Ausgangssignal des Photomultipliers PM als auch die den Ort des Laserstrahls LA auf der Probe IC repräsentierenden Ausgangssignale des Tandemverstärkers VTV anliegen. Die Meßdaten (Koordinaten der Meßstelle auf der Probe IC, Intensität der rückgestreuten Strahlung usw.) werden üblicherweise in einem dem Monitor MO zugeordneten Bildspeicher BSP abgelegt, um diese nach der Messung darstellen und auswerten zu können.

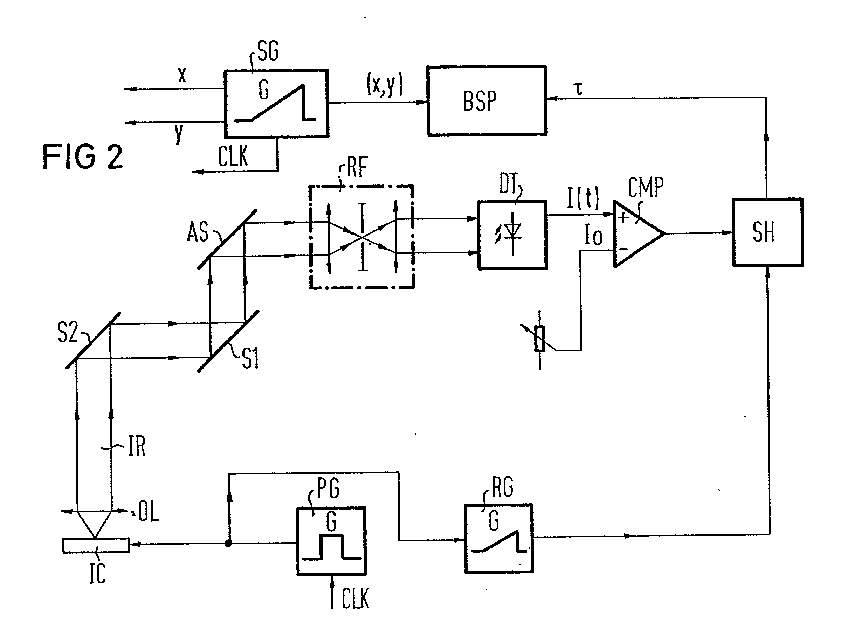

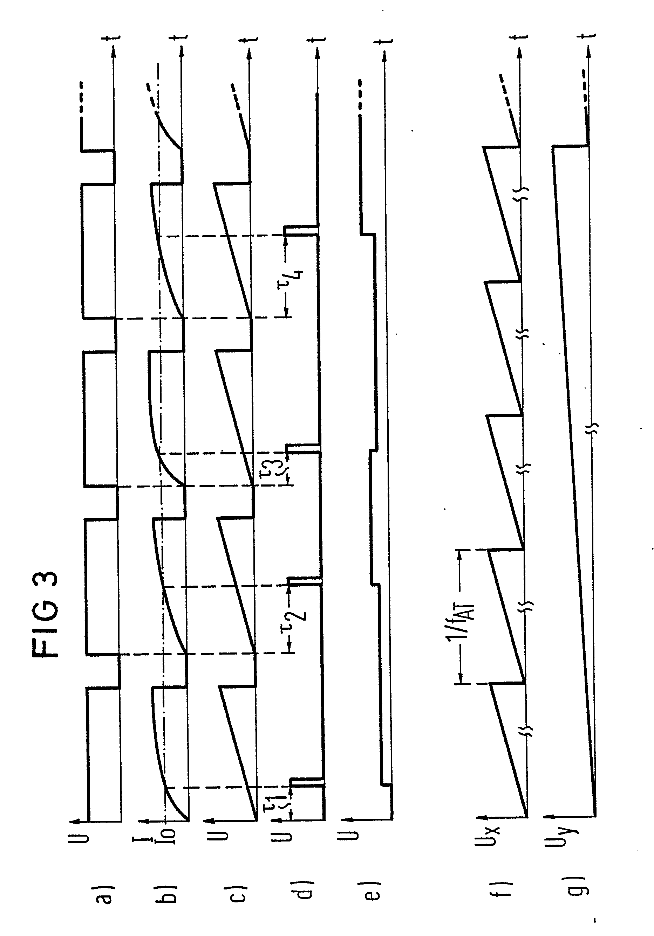

Zur Durchführung des erfindungsgemäßen Verfahrens ist das Raster-Laser-Mikroskop zusätzlich noch mit einem in den Strahlengang einbringbaren Umlenkspiegel AS ausgestattet (siehe Figur 2, in der nur die für die Durchführung des Verfahrens wesentlichen Komponenten des Raster-Laser-Mikroskops dargestellt sind), mit dem man die von der jeweiligen Meßstelle ausgehende Infrarotstrahlung IR auskoppelt und einem Detektor DT zuführt. Die Lage der Meßstelle auf der Probenoberfläche wird hierbei mit Hilfe der die Stellung der Spiegel S1 bzw. S2 definierenden Ablenkspannung des Rastergenerators SG vorgegeben. So liegen die Meßstellen rasterförmig über die Probenoberfläche verteilt, wenn man die Ansteuereinheiten AS1 und AS2 der Spiegel S1 bzw. S2 mit den in Figur 3f, g dargestellten sägezahnförmigen Signalen beaufschlagt.

Die ausgekoppelte Infrarotstrahlung durchläuft einen aus zwei Linsen und einer Lochblende (Blendendurchmesser einige $\mu$m) bestehenden Raumfilter (Unterdrückung der Stör- und Untergrund strahlung) um anschließend mit einer stickstoffgekühlten Germanium-Pin-Diode nachgewiesen zu werden. Dem Detektor DT ist ein Komparator CMP nachgeschaltet, in dem man ein die Intensität I (t) der Infrarotstrahlung IR repräsentierendes Signal mit einem vorzugsweise einstellbaren Schwellenwert $I_0$ vergleicht. Der Komparator CMP gibt immer dann ein Triggersignal an die ausgangsseitig mit einem Dateneingang des Bildspeichers BSP verbundene Sample- and Hold-Schaltung SH ab, wenn die Intensität I(t) den vorgegebenen Schwellenwert $I_0$ erreicht.

In der Probe IC wird der Latch-Up durch die gepulste Versorgungsspannung periodisch ausgelöst und unterdrückt. Die Ansteuerung der Probe IC erfolgt deshalb über einen das Latch-Up-Triggersignal erzeugenden Impulsgenerator PG, dessen Steuereingang mit einem den Meßstellenwechsel (Frequenz $f_{AT} \approx$ 100 Hz - 1kHz) definierenden Signal CLK, beispielsweise dem Internal-Clock-Signal des Rastergenerators SG, beaufschlagt ist. Das Ausgangssignal des Impulsgenerators PG (Latch-Up-Triggersignal, siehe Figur 3a) liegt hierbei auch am Eingang eines Sägezahngenerators RG an, dessen Ausgangsspannung (siehe Figur 3c) in der Sampleand Hold-Schaltung SH solange integriert wird, bis die Intensität I (t) der Infrarotstrahlung IR (siehe Figur 3b) an der jeweiligen Meßstelle den im Komparator CMP vorgegebenen Schwellenwert $I_0$ erreicht (das die Integration beendende Triggersignal des Komparators CMP ist schematisch in Figur 3d dargestellt). Das Ausgangssignal der Sample- and Hold-Schaltung SH (siehe Figur 3e) repräsentiert dann das zwischen dem Auftreten des Latch-Up-Triggersignals (Zeitpunkt $t_0$) und dem Erreichen des Schwellenwertes $I_0$ (Zeitpunkt $t_S$) liegende Zeitintervall $\tau = t_S - t_0$. Der dem Zeitintervall $\tau$ entsprechende Meßwert wird anschließend in den Bildspeicher BSP eingelesen, dessen zweiter Eingang gleichzeitig die Koordinaten der jeweiligen Meßstelle vom Rastergenerator SG übernimmt.

Nach Beendigung der Messung kann man ein Bild der Probe IC auf dem Monitor MO des Raster-Laser-Mikroskops erzeugen, wobei der das Zeitinterval $\tau = t_S - t_0$ repräsentierende Meßwert die Helligkeit der den Meßstellen jeweils zugeordneten Bildpunkte bestimmt. Linien gleicher Helligkeit zeigen dann den Ausbreitungsgrad der Latch-Up-Front zu einem bestimmten Zeitpunkt $t_S$.

Die Erfindung ist selbstverständlich nicht auf die beschriebenen Ausführungsbeispiele beschränkt. So ist es ohne weiteres möglich, eine parasitäre Thyristorstruktur auch durch einen auf einen Latch-Up-empfindlichen Bereich der Schaltung gerichteten Laser- oder Elektronenstrahl zu zünden.

Es ist selbstverständlich auch möglich, die ausgekoppelte Infrarotstrahlung mit Hilfe eines wellenlängenabhängigen Strahlteilers in zwei die Rekombinationsstrahlung und die Wärmestrahlung repräsentierende Teilstrahlen aufzuspalten und deren Intensität jeweils in einem für die betreffende Strahlung empfindlichen Detektor zu messen.

## Ansprüche

1. Verfahren zur Untersuchung der Latch-Up-Ausbreitung in CMOS-Schaltungen durch Nachweis der von der Schaltung emittierten Infrarotstrahlung (IR), dadurch gekennzeichnet, daß
- der Latch-Up periodisch ausgelöst wird.
- daß die Intensität (I (t)) der Infrarotstrahlung (IR) nacheinander an mehreren Meßstellen registriert wird,
- daß an den Meßstellen jeweils festgestellt wird, innerhalb welcher Zeitspanne ($\tau$) nach dem Auslösen des Latch-Up die Intensität (1 (t)) der Infrarotstrahlung (IR) einen Schwellenwert ($I_0$) erreicht
- und daß jeweils ein die Zeitspanne ($\tau$) repräsentierender Meßwert ortsabhängig aufgezeichnet wird.

2. Verfahren nach Anspruch 1, dadurch gekennzeichnet, daß ein Bild der Schaltung (IC) auf einem Sichtgerät (MO) erzeugt wird, wobei die Zeitspanne ($\tau$) die Helligkeit der den Meßstellen jeweils zugeordneten Bildpunkte bestimmt.

3. Verfahren nach Anspruch 1 oder 2, dadurch gekennzeichnet, daß der Latch-Up durch einen auf die Schaltung (IC) gerichteten Korpuskularstrahl (LA) ausgelöst wird.

4. Verfahren nach Anspruch 1 oder 2, dadurch gekennzeichnet, daß der Latch-Up durch ein elektrisches Triggersignal ausgelöst wird.

5. Verfahren nach einem der Ansprüche 1 bis 4, dadurch gekennzeichnet, daß die Meßstellen die Schaltung (IC) rasterförmig überdecken.

6. Anordnung zur Durchführung des Verfahrens nach Anspruch 1, gekennzeichnet durch
- ein Linsensystem (OL) zur Bündelung der von der jeweiligen Meßstelle ausgehenden Infrarotstrahlung (IR),
- eine von einem Rastergenerator (SG) angesteuerte Ablenkeinheit (S1, S2), wobei die Ausgangssignale des Rastergenerators (SG) den Ort der jeweiligen Meßstelle innerhalb der Schaltung (IC) definieren,
- eine erste Einrichtung (PG) zur Erzeugung eines den Latch-Up auslösenden Triggersignals, wobei ein Steuereingang der ersten Einrichtung (PG) mit einem den Meßstellenwechsel definierenden Signal (CLK) beaufschlagt ist,
- einen Detektor (DT) zum Nachweis der Infrarotstrahlung (IR)
- einem Komparator (CMP),
- eine zweite Einrichtung zur Erzeugung eines die Zeitspanne ($\tau$) zwischen dem Auftreten des Triggersignals und dem Erreichen eines im Komparator (CMP) vorgegebenen Schwellenwertes ($I_0$) entsprechenden Meßwerts
- und einer Speichereinheit (BSP).

7. Anordnung nach Anspruch 6, dadurch gekennzeichnet, daß die erste Einrichtung aus einer die Schaltung (IC) ansteuernden Impulsgenerator (PG) besteht.

8. Anordnung nach Anspruch 6 oder 7, dadurch gekennzeichnet, daß die zweite Einrichtung einen eingangsseitig mit dem Triggersignal beaufschlagten Sägezahngenerator (RG) und einen eingangsseitig mit dem Ausgang des Sägezahngenerators (RG) verbundene Sample and Hold-Schaltung (SH) aufweist, wobei der Triggereingang der Sample and Hold-Schaltung (SH) mit dem Ausgangssignal des Komparators (CMP) beaufschlagt ist.

9. Anordnung nach einem der Ansprüche 6 bis 8, gekennzeichnet durch einen dem Detektor (DT) vorgelagerten Raumfilter (RF).

FIG 1

EP 0 345 701 A2

FIG 2

FIG 3